# FASCICULE DE BREVET EUROPEEN

(11) **EP 3 220 426 B1**
(45) Date de publication et mention de la délivrance du brevet: **03.10.2018**
(21) Numéro de dépôt: 17305259.8
(22) Date de dépôt: 10.03.2017
(51) Int. Cl.: H01L 31/173, H04B 10/116

(54) **CIRCUIT INTÉGRÉ DE TYPE CMOS APTE À TRANSMETTRE DE L'INFORMATION À DISTANCE PAR L'INTERMÉDIAIRE DE FAISCEAUX LUMINEUX DE FAÇON BIDIRECTIONNELLE EN UTILISANT PLUSIEURS CANAUX DE TRANSMISSION**
INTEGRIERTER SCHALTKREIS VOM TYP CMOS FÜR DIE BIDIREKTIONALE FERNÜBERTRAGUNG VON INFORMATIONEN ÜBER LICHTSTRAHLEN UNTER VERWENDUNG MEHRERER ÜBERTRAGUNGSKANÄLE
CMOS INTEGRATED CIRCUIT CAPABLE OF TRANSMITTING INFORMATION REMOTELY VIA BIDIRECTIONAL LIGHT BEAMS USING SEVERAL TRANSMISSION CHANNELS

(30) Priorité: 14.03.2016 FR 1652099
(43) Date de publication de la demande: 20.09.2017
(73) Titulaire: PI Lighting, 1950 Sion (CH)
(72) Inventeur: MERELLE, Thomas, 1950 SION (CH); BATAILLOU, Benoît, 1950 SION (CH)
(74) Mandataire: Jacobacci Coralis Harle

(56) Documents cités:
- WO-A1-2015/057771
- FR-A1- 2 997 590
- US-A1- 2013 075 761
- DATIRI NINRAT B ET AL: "The Smart Room: a 100 Mb/s integrated optical access point transceiver for indoor visible light communication", BROADBAND ACCESS COMMUNICATION TECHNOLOGIES VI, SPIE, 1000 20TH ST. BELLINGHAM WA 98225-6705 USA, vol. 8282, no. 1, 21 janvier 2012 (2012-01-21), pages 1-13, XP060001107, DOI: 10.1117/12.910159

## Description

### Domaine technique de l'invention

La présente demande concerne un circuit intégré apte à échanger de l'information bidirectionnelle avec un autre circuit intégré par l'intermédiaire de faisceaux lumineux. L'invention a également attrait à un procédé de fabrication dudit circuit.

### État de la technique

L'emploi des fibres optiques dans le domaine des télécommunications a permis d'augmenter considérablement la quantité d'information échangée. En effet, une fibre optique permet en moyenne d'échanger 1 000 Mégabits de données par seconde entre un réseau de communication et un terminal. Par le terme « terminal », on entend tout dispositif permettant de recevoir et/ou d'émettre de l'information, par exemple une télévision, un ordinateur, un téléphone portable, etc.

Néanmoins, pour des raisons d'ordre pratique et économique, les terminaux ne sont pas directement connectés à une fibre optique principale permettant d'accéder à un réseau de communication. En effet, cela nécessiterait de relier physiquement chaque terminal à la fibre optique principale par l'intermédiaire d'une fibre optique secondaire, ce qui représente un coût d'installation non négligeable et l'inconvénient de limiter le déplacement de chaque terminal. C'est pourquoi on préfère généralement assurer la transmission de l'information entre la fibre optique principale et un terminal par d'autres moyens.

Un premier moyen consiste à transmettre l'information par l'intermédiaire de l'installation électrique d'un bâtiment. Plus précisément, l'information est transmise par la mise en oeuvre de la technique des Courants Porteurs en Ligne (CPL) qui consiste à superposer à un courant électrique un signal de plus haute fréquence, entre un premier boîtier CPL connecté à la fibre optique principale et un deuxième boîtier CPL connecté au terminal souhaité. Cette technologie est donc moins coûteuse à mettre en oeuvre, car elle utilise une installation électrique existante, mais elle a pour inconvénient de devoir relier physiquement chaque terminal à un deuxième boîtier CPL, limitant de ce fait leur déplacement dans le bâtiment.

Afin de pallier cet inconvénient, il est préféré l'utilisation de la technologie « WIFI » qui permet de façon avantageuse d'échanger de l'information entre une fibre optique principale et un terminal, sans utiliser de lien physique. Plus précisément, les informations sont transmises entre la fibre optique principale et plusieurs terminaux par l'intermédiaire de boîtiers communicants par ondes électromagnétiques.

Ces deux solutions ont pour inconvénient d'offrir un débit de transmission nettement inférieur à celui de la fibre optique principale. En effet, le débit de transmission est respectivement en moyenne de l'ordre de 50 Mégabits et de 200Mégabits de données par seconde pour le CPL et le « WIFI »). Il apparait donc que l'utilisation de l'une ou l'autre de ces technologies bride le débit d'information que la fibre optique principale transmet au terminal.

L'utilisation du « WIFI » semble également présenter un risque sanitaire pour certains utilisateurs dits électrosensibles. Les personnes électrosensibles sont incommodées, plus ou moins gravement, par les fréquences des ondes électromagnétiques utilisées par le « WIFI ». Selon un autre inconvénient, ces plages de fréquences se recoupent avec celles exploitées par d'autres appareils, par exemple les fours à micro-ondes. De ce fait, un signal « WIFI » peut perturber ou bien être perturbé par le fonctionnement d'autres appareils domestiques. Selon un autre inconvénient, dans un réseau « WIFI » les ondes électromagnétiques sont émises dans toutes les directions, de plus les plages de fréquences utilisées sont sensiblement les mêmes pour chaque réseau « WIFI ». Les informations échangées dans un réseau « WIFI » peuvent ainsi être accessibles à d'autres réseaux « WIFI » couvrant la même zone et donc être interceptées par un utilisateur non autorisé. Par conséquent, l'utilisation de la technologie « WIFI » présente un risque de confidentialité pour les informations transmises entre la fibre optique principale et un terminal. Les points discutés dans ce paragraphe devenant particulièrement critiques avec la tendance actuelle de l'internet des objets : la multiplication des objets connectés sans fil étant vouée à augmenter considérablement dans les prochaines années, autant dans les lieux de vie publique que privée.

Le document WO 2015/057771 A propose une alternative à l'utilisation d'un signal « WIFI », en proposant l'emploi de circuits intégrés, aptes à transmettre de l'information à distance par l'intermédiaire de faisceau lumineux. Pour cela chaque dispositif comprend un substrat sur lequel est disposé sur une même face au moins une unité de communication comprenant un moyen d'émission et un moyen de réception d'un rayonnement électromagnétique dont la plage de longueur d'onde est comprise entre 200 nm et 3 µm. Chaque unité de communication est apte à échanger de l'information avec une autre unité de communication agencée sur un autre circuit intégré, par l'intermédiaire du rayonnement électromagnétique de façon bidirectionnelle. Toutefois, ce mode de réalisation n'offre pas actuellement un débit d'information suffisant par rapport à la quantité d'information transportée par une fibre optique.

La présente demande vise à proposer un dispositif permettant de préserver le débit d'information transmis entre une fibre optique et un terminal, ainsi que de permettre un échange d'information plus sécurisé et moins dangereux pour l'utilisateur.

### Description de l'invention

Pour cela, la présente demande propose un circuit intégré apte à transmettre de l'information à distance par l'intermédiaire de faisceaux lumineux tel que défini dans la revendication 1. Par le terme « information », on entend un échange de données numériques entre deux unités de communication présentes sur des circuits intégrés.
Le circuit intégré comprend un substrat sur lequel sont agencées, sur une même face, plusieurs unités de communication comprenant un moyen d'émission et un moyen de réception d'un rayonnement électromagnétique dont la plage de longueur d'onde est comprise entre 200nm et 3µm, de préférence entre 380nm et 780nm. Par les termes « moyen de réception », on entend un moyen apte à recevoir un faisceau lumineux et permettre la mesure de sa fréquence. Chaque unité de communication est apte à échanger de l'information avec une autre unité de communication agencée sur un autre circuit intégré, par l'intermédiaire du rayonnement électromagnétique, et ce, de façon bidirectionnelle. A chaque unité de communication est associée une combinaison unique de plage de longueur d'onde de rayonnement électromagnétique et une plage de fréquence d'échange d'information. Autrement dit, les unités de communication ont en outre l'avantage que chacune d'entre elle est spécifique en longueur d'onde de rayonnement électromagnétique et en fréquence d'échange d'information.

Ainsi, à chaque unité de communication est associée une plage de longueur d'onde et une fréquence ou une plage de fréquence spécifique, afin de pouvoir échanger plusieurs informations simultanément entre deux circuits intégrés. Ce mode de réalisation permet d'accroître facilement le débit d'information entre lesdits circuits en fonction du nombre d'unités de communication agencées sur leur substrat. À titre d'exemple, sur une même face du substrat d'un circuit intégré peuvent être agencées au moins 4 ou 16 ou 64 ou 128 unités de communication.

L'invention est remarquable en ce que sur une même face du substrat du circuit intégré sont agencées plusieurs unités de communication sous forme de lignes et de colonnes, et aux unités de communication formant une colonne est associée une plage unique de longueurs d'onde d'un rayonnement électromagnétique et aux unités de communication formant une ligne est associée une fréquence unique d'échange d'information. Chaque moyen d'émission/réception est ainsi aisément adressable via des « bitlines » et « wordlines » comme cela est fait dans tout design de circuit mémoriel (SRAM, DRAM, NVRAM). En outre, un filtre optique peut par exemple être agencé devant au moins une diode électroluminescente et/ou au moins une photodiode. Selon un mode de réalisation préféré, un filtre optique spécifique peut être est placé devant chaque colonne formée par les unités de communication. Par les termes « filtre optique spécifique », on entend un filtre optique laissant passer uniquement une plage de longueur d'onde choisie. On choisit une plage de longueur d'onde unique pour chaque colonne formée par les unités de communication.

De façon avantageuse, les plages de longueurs d'onde exploitées par l'invention se dissocient suffisamment des plages de longueurs d'onde utilisées par le « WIFI » pour ne pas incommoder un utilisateur ou bien interférer avec d'autres appareils domestiques, comme mentionné ci-dessus. Selon un autre avantage, l'invention permet plus aisément de contrôler la diffusion de l'information émise par le circuit intégré dans son environnement. En effet, dans les plages de longueurs d'onde exploitées par l'invention, la propagation d'un rayonnement électromagnétique peut facilement être stoppée par un matériau optiquement opaque. Par les termes « matériau optiquement opaque », on entend tout matériau susceptible de stopper un faisceau de lumière visible par un utilisateur. De ce fait, l'information émise par le circuit intégré peut par exemple être confinée par les murs d'une pièce, de manière à empêcher toute personne se trouvant à l'extérieur de la pièce d'intercepter cette information. En d'autres termes, un ou plusieurs moyens de réception situés en vis-à-vis direct d'un moyen d'émission sont aptes à recevoir le rayonnement électromagnétique. De ce fait, la transmission d'informations peut se faire de façon plus sécurisée entre deux circuits intégrés selon la présente demande. Un autre avantage de cette technologie est la distance de réception. En l'absence de matériau optiquement opaque, une émission lumineuse à une longueur d'onde donnée pouvant être détectée à une distance nettement supérieure à ce que propose le « WIFI » dans ses normes actuelles (« Wifi AC » et antérieur). De nuit, sans pollution lumineuse conséquente, le rayonnement lumineux d'une LED est ainsi détectable à plus d'un kilomètre par une photodiode standard.

Selon une caractéristique de l'invention, le substrat comprend sur une même face au moins deux unités de communication distinctes et chaque unité de communication comprend un moyen d'émission et un moyen de réception d'un rayonnement électromagnétique dans une même plage de longueur d'onde. Ainsi, en cas de dysfonctionnement d'une unité de communication, la transmission d'informations peut être poursuivie par l'intermédiaire des autres unités de communication.

Selon une autre caractéristique de l'invention, le substrat comprend sur une même face au moins deux unités de communication distinctes et lesdites unités de communication échangent de l'information à une même fréquence. À titre d'exemple non limitatif, chaque unité de communication peut échanger de l'information à une fréquence comprise entre 1Hz et 4GHz, de préférence entre 400MHz et 1,5GHz.

Selon une caractéristique de l'invention, le moyen d'émission et/ou le moyen de réception peut comprendre une jonction de type P-N et au moins un transistor à effet de champ dont la grille recouvre au moins partiellement les zones dopées négativement et positivement de ladite jonction, de sorte qu'une desdites zones dopées forme également la source ou le drain du transistor. Autrement dit, le moyen d'émission ou le moyen de réception a en commun une zone dopée avec la jonction de type P-N. Cette configuration permet avantageusement de s'affranchir de l'emploi de moyens de connexion entre ces éléments, limitant ainsi les possibles courants de fuite, tout en améliorant la conduction du courant entre eux. Selon un autre avantage, cet agencement permet également d'obtenir un assemblage plus compact.

Selon un autre mode de réalisation préféré, un moyen d'émission peut comprendre une diode électroluminescente et un moyen de réception peut comprendre une photodiode. Selon une alternative, le moyen d'émission peut comprendre une source de lumière cohérente de type diode LASER, permettant une meilleure précision dans l'alignement d'un moyen d'émission et un moyen de réception. Il est à noter qu'une diode électroluminescente ou une photodiode est de préférence connectée à un ou plusieurs transistors, de préférence quatre transistors situés de chaque côté des diodes d'émission et de réception afin d'optimiser le passage d'un courant entre ces différents éléments. La densité de courant affluant des transistors vers la diode pour l'émission ou affluant de la diode vers les transistors pour la réception est ainsi topologiquement optimale.

Selon une autre variante de réalisation de l'invention, la plage de longueur d'onde de rayonnement électromagnétique et/ou la plage de fréquence d'échange d'information d'au moins une unité de communication peut changer au cours du temps, de préférence toutes les secondes ou toutes les millisecondes, selon une clé séquentielle que seul l'émetteur et le récepteur de la communication bidirectionnelle ont en leur possession afin de préserver la confidentialité des informations transmises. Cette clé de codage pouvant avantageusement être implémentée soit directement dans le composant grâce un circuit de type « hardware », soit via un logiciel de type « software » qui se chargera de commander l'adressage du composant.

Selon une autre caractéristique de l'invention, le circuit intégré peut comprendre des moyens de correction d'erreur permettant de compléter une information partiellement transmise entre deux circuits intégrés selon la présente demande. À titre d'exemple, les moyens de correction peuvent désigner un ajout de redondance comme dans les codes de « Hamming », très utilisés dans le domaine des communications digitales et des systèmes de sauvegarde de données. À titre d'exemple, les moyens de correction peuvent coder un mot de k bits en ajoutant m bits, de façon à obtenir des mots codés de n bits. On obtient ainsi la corrélation suivante : m = n - k. Les bits sont calculés de façon connue à l'aide d'une matrice génératrice. On obtient de la sorte un code avec une distance minimale de 3, permettant aux moyens de correction de détecter 2 erreurs et d'en corriger 1.

Selon un mode de réalisation préféré, un transistor est connecté à un moyen d'émission et au moins un autre transistor est connecté à un moyen de réception, chaque transistor comprenant un canal de conduction, et en ce qu'au moins un transistor connecté au moyen d'émission comporte un canal de conduction plus large et/ou plus court qu'un transistor connecté au moyen de réception. Autrement dit, on opte pour un canal de conduction de plus grande largeur et/ou plus court pour un transistor connecté à un moyen d'émission, par rapport à un transistor connecté à un moyen de réception. Cette configuration permet de façon avantageuse de favoriser le passage d'un courant plus important entre le transistor et le moyen d'émission qu'entre l'autre transistor et le moyen de réception. De préférence, le rapport largeur sur longueur d'un canal de conduction d'un transistor connecté à un moyen d'émission, est égal ou supérieur à 50, de préférence égal ou supérieur à 100, au rapport largeur sur longueur d'un canal de conduction d'un autre transistor connecté à un moyen de réception. Ce mode de réalisation vise à permettre un fonctionnement optimum du moyen d'émission. En effet, le courant nécessaire pour le bon fonctionnement d'un moyen d'émission par exemple une diode électroluminescente est bien supérieur à celui produit par un moyen de réception tel qu'une photodiode, à surface active similaire. Par les termes « surface active », on entend par exemple la surface d'émission de la diode ou la surface de réception de la photodiode.

De façon plus générale, la présente demande porte également sur des dispositifs intégrant un circuit intégré tel que décrit ci-dessus. Un circuit intégré selon la présente demande peut faire partie d'un terminal de réception et/ou de d'émission d'information. À titre d'exemple, un circuit intégré peut être intégré dans un modem connecté à une fibre optique principale, un « Smartphone » également appelé téléphone intelligent, une télévision, un ordinateur, un moniteur d'ordinateur, un vidéo projecteur, un casque de réalité virtuelle, un serveur, une source d'éclairage et de manière générale, tout appareil électronique contenant une diode électroluminescente. L'invention est particulièrement pertinente pour un casque de réalité virtuelle, ceux disponibles sur le marché au moment de la rédaction de ce brevet étant toujours reliés par un câble à un ordinateur pour le transfert du flux vidéo qui nécessite un large débit. Cette invention permet de s'affranchir d'un tel câble par une communication sans fil, grâce à un circuit intégré selon l'invention placé par exemple sur le haut du casque et un autre placé par exemple au plafond.

La présente demande concerne également un procédé de fabrication d'un circuit intégré décrit ci-dessus, comprenant au moins une étape consistant à réaliser de façon symétrique, sur le substrat du circuit intégré, au moins deux transistors à effet de champ à grille isolée de type N (NMOS), ou de type P (PMOS), ou de type N et P. En d'autres termes, un circuit intégré selon l'invention peut être fabriqué par la mise en oeuvre d'un procédé du type CMOS ou « Complementary Metal Oxide Semiconductor », par exemple décrit dans le document écrit par M. John P. Uyemura dans l'ouvrage intitulé « CMOS LOGIC CIRCUIT DESIGN », en pages 61 à 102 (ISBN : 978-0-306-47529-0). Ainsi, la présente demande porte plus particulièrement sur un circuit intégré tel que décrit ci-dessus, obtenu à partir d'un procédé de type CMOS, apte à transmettre de l'information à distance par l'intermédiaire de faisceaux lumineux, de préférence de façon bidirectionnelle, en utilisant un ou plusieurs canaux de transmission. La technologie CMOS possède de multiples avantages. Ce procédé de fabrication étant de loin le plus répandu dans toute l'industrie du semi-conducteur, son cout de fabrication est minimisé. En outre, elle permet une intégration aisée de ce composant dans une puce possédant d'autres fonctionnalités (mémoire SRAM, MRAM ou DRAM, modem 4G ou 5G, processeur de calcul « CPU », processeur graphique « GPU », circuit dédié « ASIC », circuit de traitement de flux vidéo, etc...). Le procédé de type « CMOS » permet d'isoler électriquement la partie du substrat contenant les transistors de champ à grille isolée de type N (NMOS) de ceux de type P (PMOS) grâce à la jonction entre le caisson d'isolation et le substrat, permettant ainsi de garantir une excellente isolation électrique entre la partie émettrice et la partie réceptrice de l'invention. Enfin, l'emploi d'une technologie « CMOS » permet également de bénéficier de toute la recherche et développement déjà mise en place sur les chaînes de production pour les capteurs « CMOS » pour appareils photo et caméra vidéo. En effet, la partie supérieure des puces « CMOS » contenant les couches de métallisation de cuivre ou d'aluminium (appelée « back-end ») permettant de relier chacun de ses microcomposants pour former le circuit adéquat a nécessité par le passé des efforts de R&D afin de pouvoir également y insérer des optiques afin de guider la lumière vers les photodiodes et des filtres capables de la filtrer. Pour plus de détails, l'ouvrage intitulé « CMOS/CCD Sensors and Camera Systems, Second Edition » (ISBN: 9780819486530) décrit le principe de fonctionnement des capteurs CMOS au chapitre 4, de la page 90 à la page 117.

Selon une alternative, le procédé de fabrication peut comprendre les étapes suivantes :
- réalisation d'un transistor de type P dans une zone active du circuit intégré de sorte que le transistor soit entouré d'une tranchée d'isolation et présent dans un caisson d'isolation dopé faiblement de type N ;
- recouvrement d'au moins une partie du drain du transistor de type P par une diode électroluminescente.

L'avantage de cette solution est sa plus grande flexibilité dans l'étape de recouvrement des diodes électroluminescentes (soit par épitaxie, soit par collage à la fin de la fabrication du composant CMOS).

Selon une alternative, le procédé de fabrication peut comprendre les étapes suivantes :
- réalisation d'un transistor de type N dans une zone active du circuit intégré de sorte que le transistor soit entouré d'une tranchée d'isolation et présent dans un caisson d'isolation dopé faiblement de type P ;
- recouvrement d'au moins une partie de la source du transistor de type N par une photodiode.

L'avantage de cette solution est la plus grande flexibilité dans l'étape de recouvrement des photodiodes (soit par épitaxie, soit par collage à la fin de la fabrication du composant CMOS).

Selon une variante de réalisation d'un procédé de fabrication d'un circuit intégré décrit ci-dessus, le procédé peut comprendre les étapes suivantes :
- réalisation d'une diode électroluminescente comprenant au moins une zone dopée de type P et au moins une zone dopée de type N, lesdites zones étant séparées par une couche de puits quantiques ;
- réalisation d'un transistor de type N dans une zone active du circuit intégré de sorte que le transistor soit présent dans un caisson d'isolation dopé de type P, et qu'une grille du transistor de type N recouvre au moins partiellement une source dudit transistor, caractérisé en ce que la source du transistor est commune à une zone dopée de type N de la diode électroluminescente, et en ce qu'une zone dopée de type P de la diode électroluminescente forme au moins une partie du canal de conduction du transistor.

L'avantage de cette solution est la possibilité de fabriquer directement la diode électroluminescente durant le procédé de fabrication « CMOS », dans le substrat. En effet, les diodes électroluminescentes sont directement intégrées dans les transistors d'accès, car constituant aussi la jonction de la source desdits transistors, ce qui a l'avantage de supprimer la capacité et la résistance parasite d'une jonction, améliorant ainsi la réactivité et la performance du composant formé. Par les termes « couche de puits quantiques », on désigne une couche apte à générer un faisceau lumineux lorsque la diode électroluminescente est mise sous tension. Par le terme « commun », on entend ici qu'une zone ou une couche du circuit intégré constitue à la fois un élément de la diode électroluminescente et un élément du transistor.

Selon une autre variante de réalisation d'un procédé de fabrication d'un circuit intégré décrit ci-dessus, le procédé peut comprendre les étapes suivantes :
- réalisation d'une photodiode comprenant au moins une zone dopée de type P et au moins une zone dopée de type N, les zones dopées étant séparées par une couche apte à créer une zone de déplétion entre lesdites zones ;
- réalisation d'un transistor de type P dans une zone active du circuit intégré de sorte que le transistor soit présent dans un caisson d'isolation dopé de type N, et qu'une grille recouvre au moins partiellement un drain du transistor, caractérisé en ce que le drain du transistor est commun à une zone dopée de type P de la photodiode, et en ce qu'une zone dopée de type N de la photodiode forme au moins une partie du canal de conduction du transistor.

Les avantages de cette solution sont : (i) la possibilité de fabriquer directement la photodiode durant le procédé de fabrication CMOS, dans le substrat, ce qui est aisément réalisable étant donné que la grande majorité des photodiodes emploie uniquement du silicium dopé; (ii) le fait que les photodiodes sont directement intégrées dans les transistors d'accès car constituant aussi la jonction du drain desdits transistors, ce qui a l'avantage de supprimer la capacité et la résistance parasite d'une jonction, améliorant d'autant la réactivité et la performance du composant ainsi formé.

La présente demande a également attrait à un kit comportant au moins deux circuits intégrés selon l'une des revendications précédentes, chaque circuit intégré comprenant une ou plusieurs unités de communication agencées sur une même face. Le kit vise à permettre la transmission d'informations de façon rapide et sécurisée entre les deux circuits intégrés tels que décrits ci-dessus.

De préférence, au moins deux circuits intégrés comprennent des unités de communication qui sont agencées de sorte que lorsque lesdits circuits sont en vis-à-vis, chaque unité de communication est en vis-à-vis d'une unité de communication apte à échanger de l'information dans une même plage de longueur d'onde de rayonnement électromagnétique et à une même fréquence d'échange d'information. En d'autres termes, les unités de communication sont agencées de façon identique sur chaque circuit intégré de sorte que chaque unité de communication soit en vis-à-vis d'une autre unité de communication lorsque les circuits intégrés se font face.

Selon une variante de réalisation, un kit peut comprendre des moyens de guidage optique permettant de guider le rayonnement électromagnétique entre deux unités de communication agencées sur des circuits intégrés distincts. Les termes « moyens de guidage optique » peuvent désigner de façon non exclusive au moins une fibre optique, un miroir, un prisme ou une lentille. De façon avantageuse, les moyens de guidage optique permettent de transmettre le rayonnement électromagnétique entre des unités de communication même lorsqu'elles ne sont pas alignées. L'utilisation des moyens de guidage optique permet ainsi une plus grande liberté dans le positionnement relatif de deux circuits intégrés, lesdits moyens permettent également un meilleur confinement du rayonnement électromagnétique et donc une plus grande sécurité dans la transmission d'informations. Selon un autre avantage, les moyens de guidage optique peuvent prévenir d'une gêne pour l'utilisateur dû aux rayonnements électromagnétiques entre les circuits intégrés, en cachant lesdits rayonnements de l'utilisateur, par l'emploi de fibres optiques gainées par exemple.

Selon des modes préférés de réalisation, une fibre optique unique peut être utilisée pour transmettre les faisceaux de lumière entre :
- deux circuits intégrés ;
- entre des unités de communication émettant dans la même plage de longueur d'onde ; et/ou bien
- entre des unités de communication émettant à la même fréquence ; ou
- entre seulement deux unités de communication.

Un kit selon l'invention peut ainsi permettre de préserver le débit d'informations entre un modem connecté à une fibre optique principale et un terminal situé à distance du modem, par exemple un poste de télévision ou un ordinateur. Un kit selon la présente demande peut également être utilisé pour établir une communication de type sans fil, entre un émetteur de flux vidéo à très haute résolution (ordinateur, serveur, console de jeu vidéo, « Smartphone ») et un écran à très haute résolution (téléviseur 4K, moniteur d'ordinateur, vidéo projecteur, casque de réalité virtuelle).

Bien entendu, les différentes caractéristiques, les différentes variantes et les différentes formes de réalisation de l'invention peuvent être associées les unes aux autres selon diverses combinaisons, dans la mesure où elles ne sont pas incompatibles ou exclusives les unes des autres.

### Description des figures

Les caractéristiques de l'invention mentionnées ci-dessus, ainsi que d'autres, apparaîtront plus clairement à la lecture de la description des exemples de réalisation ci-dessous, en se référant aux dessins annexés sur lesquels :
- la figure 1 représente une vue de dessus d'un circuit intégré présentant une unité de communication;
- la figure 2 représente une coupe transversale du circuit intégré illustré à la figure 1 ;
- la figure 3 représente une vue de dessus d'un circuit intégré présentant un autre type d'unité de communication;
- la figure 4 représente une coupe transversale du circuit intégré illustré à la figure 3 ;
- la figure 5 représente une vue de dessus d'un circuit intégré présentant un troisième type d'unité de communication ;
- la figure 6 représente une coupe transversale du circuit intégré illustré à la figure 5 ;
- la figure 7 représente une vue de dessus d'un circuit intégré selon un mode de réalisation de l'invention.

### Description détaillée de l'invention

Pour rappel, la présente demande vise à proposer un dispositif pouvant permettre, entre autres, de préserver le débit d'information transmis entre une fibre optique et un terminal, ainsi que de permettre un échange d'information plus sécurisé et moins dangereux pour l'utilisateur.

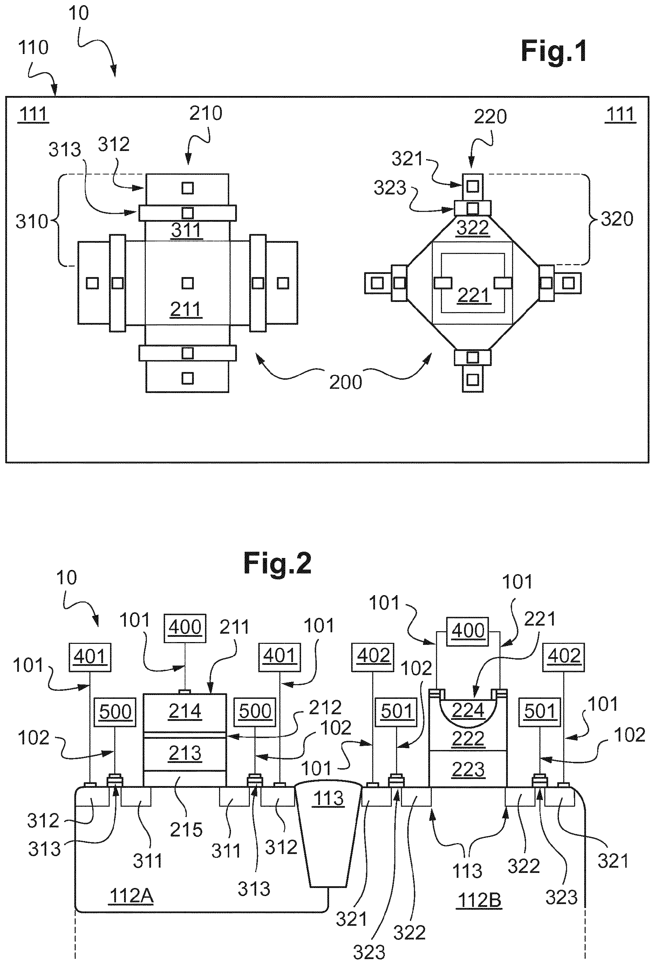

Un premier exemple d'unité de communication pour un tel dispositif est illustré aux figures 1 et 2. Plus précisément, ces figures montrent un circuit intégré 10 comprenant un substrat 110, couramment utilisé dans le domaine de la microélectronique pour réaliser des circuits intégrés. Selon le présent exemple, le substrat 110 est une plaque à base de silicium. Sur une face avant 111 du substrat est réalisé de façon connue des tranchées 113 dites d'isolation, peu profonde de type « STI » ou « shallow trench isolation », permettant d'isoler électriquement différentes zones actives sur le substrat. Par « zone active », on entend une zone de conduction du courant. Chaque zone active comprend un caisson 112a faiblement dopé de type N et un caisson 112b faiblement dopé de type P. La zone active comprend également des pistes conductrices en silicium sous la forme de drains 311 et 321, et de sources 312 et 322, respectivement fortement dopées positivement (de type P) et négativement (de type N).

Comme illustré à la figure 1, l'unité de communication 200 se compose d'un moyen d'émission 210 et d'un moyen de réception 220 d'un rayonnement électromagnétique. Le moyen d'émission et le moyen de réception disposent tous deux d'une face dite « active », permettant respectivement d'émettre ou de le détecter le rayonnement électromagnétique. Bien entendu, les moyens d'émission et de réception sont agencés sur la face avant 111 de sorte que leur face active 211 et 221 soit visible.

Selon le présent exemple, le moyen d'émission 210 est une diode électroluminescente apte à émettre un rayonnement électromagnétique dont la longueur d'onde peut être comprise entre 200nm et 3µm. Le moyen de réception 220 est une photodiode apte à détecter le rayonnement électromagnétique émis par la diode électroluminescente. Selon une alternative, la diode électroluminescente peut être substituée par une diode « LASER » permettant une meilleure directivité du rayonnement électromagnétique.

Comme illustré à la figure 2, la diode électroluminescente comprend une couche de puits quantique 212 intercalée entre une couche inférieure 213 et une couche supérieure 214. La couche de puits quantique désigne la zone de la diode apte à produire un faisceau lumineux. Selon le présent exemple, la couche inférieure 213 est formée à partir de nitrure de gallium dopé de type P et la couche supérieure 214 est formée à partir du même matériau dopé de type N. Sous la couche inférieure se trouve une couche de réflexion 215 à base de nickel et d'argent, afin d'améliorer le rendement de la diode.

La diode est alimentée en courant par l'intermédiaire de quatre transistors 310 de type P, également appelés transistors PMOS ci-dessous. Plus précisément, chaque transistor 310 PMOS comporte un drain 311 en contact avec la couche de réflexion 215 de la diode électroluminescente. Afin de permettre une alimentation optimale en courant de la diode, la largeur des drains 311 est de préférence la plus large possible. Dans le cas présent, chaque drain 311 à une largeur égale à la largeur d'un côté de la diode. Bien entendu, cette largeur peut être adaptée en fonction de la consommation en courant requise par la diode. Elle peut par exemple correspondre à plus de 50% ou plus de 80% de la largeur d'une face de la diode.

Comme représenté à la figure 2, la couche supérieure 214 de la diode est connectée à la terre 400 (GND=0V) par l'intermédiaire d'une liaison électrique 101. Chaque source 312 des transistors PMOS est connectée à une source de courant 401 servant à alimenter la diode électroluminescente. Chaque grille 313 des transistors 310 est connectée par l'intermédiaire de liaison électrique 102 à un moyen de contrôle 500 en tension de la grille des transistors PMOS afin de contrôler le fonctionnement de la diode. De façon avantageuse, les quatre grilles 313 des transistors PMOS sont connectées entres elles par des interconnections métalliques, tout comme les sont les quatre sources 312, formant ainsi un transistor effectif dont la puissance de conduction du courant est égale à 4 fois celle d'un seul des quatre transistors.

La photodiode, formant le moyen de réception 220, comprend une couche 222 à base de silicium intrinsèque (non dopée), séparant une couche inférieure 223 d'une couche supérieure 224, également en silicium. Les couches inférieure et supérieure sont respectivement dopées négativement et positivement. Comme illustré à la figure 1, la photodiode est également connectée à quatre transistors 320 de type N, également appelés transistors NMOS ci-dessous. Plus précisément, chaque transistor 320 NMOS comporte une source 322 en contact avec la couche inférieure 223 de la photodiode. La couche supérieure 224 de la photodiode est connectée à la terre 400 (GND=0V) par l'intermédiaire d'une liaison électrique 101. Chaque drain des 321 des transistors NMOS est connecté à un dispositif de mesure 402 du courant afin de lire la quantité de lumière ayant pénétré dans la photodiode. Chaque grille 323 des transistors 320 est connectée par l'intermédiaire de liaison électrique 102 au dispositif de contrôle 501 en tension de la grille des transistors NMOS, afin de contrôler le fonctionnement de la photodiode.

Comme représenté à la figure 1, il est à noter que les largeurs des grilles 313 des transistors 310 PMOS sont plus importantes que la largeur des grilles 323 des transistors 320 NMOS. Cette différence est due au fait que la quantité de courant nécessaire au bon fonctionnement de la diode électroluminescente est nettement supérieure à celui nécessaire au fonctionnement de la photodiode. En effet, la photodiode peut signaler la réception d'un rayonnement électromagnétique en produisant un courant dont la valeur peut être 100 fois moindre que la valeur du courant nécessaire à la diode électroluminescente pour émettre un rayonnement. De ce fait, on privilégie des largeurs de canaux de conduction plus importants pour les transistors 310 que pour les transistors 320. On peut ainsi réaliser une unité de communication plus performante pour un coût de production moindre, en sélectionnant les transistors en fonction du moyen auquel ils sont connectés. Selon une alternative, on peut aussi modifier la longueur des grilles pour atteindre le même objectif : plus la longueur de grille est courte, plus forte sera la conduction dans le transistor. Toutefois, on privilégie de modifier la largeur plutôt que la longueur afin de faciliter la conception et la réalisation du circuit intégré 200.

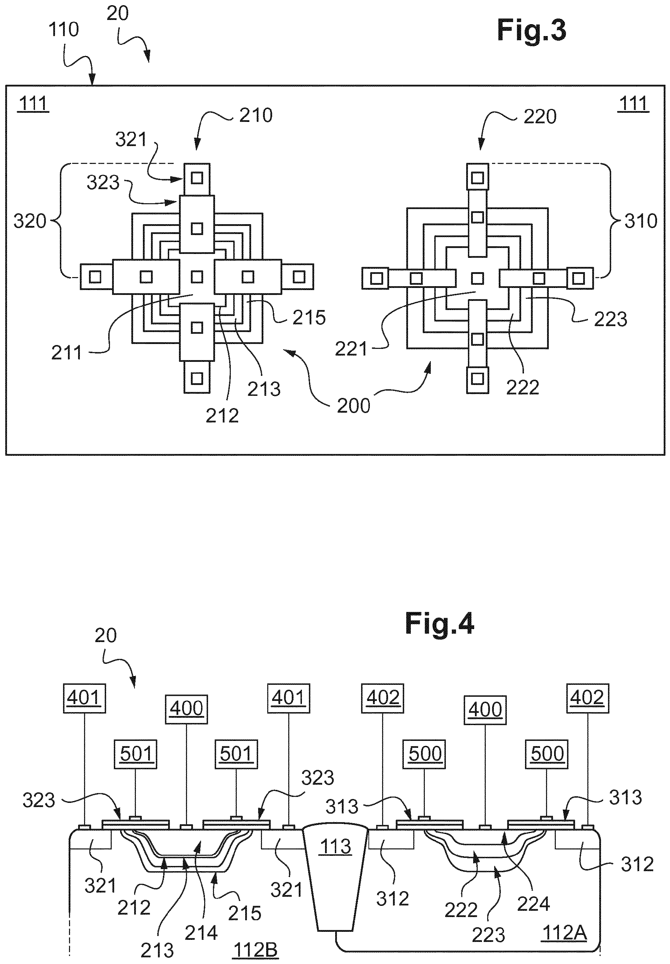

Un deuxième circuit intégré 20 présentant une unité de communication est à présent illustré aux figures 3 et 4. Ce deuxième type d'unité de communication diffère du premier en ce que la diode et la photodiode sont intégrées au substrat en silicium. Plus précisément, comme illustrée à la figure 4, leur couche supérieure affleure au niveau de la face avant 111 du substrat. L'intégration dans le substrat des moyens d'émission et de réception permet avantageusement de minimiser l'encombrement de l'unité de communication tout en réduisant les courants de fuite et en augmentant la performance électrique du dispositif.

Comme illustré à la figure 3, la diode électroluminescente est alimentée en courant par quatre transistors 320 NMOS Plus précisément, la couche supérieure 214 de la diode électroluminescente est connectée à la terre 400 (GND=0V) par l'intermédiaire de liaisons électriques 101. Chaque drain 321 des transistors NMOS est connecté à une source de courant 401 servant à alimenter la diode électroluminescente. Chaque grille 323 des transistors NMOS est connectée par l'intermédiaire de liaisons électriques 102 au dispositif de contrôle 501 en tension de la grille des transistors NMOS, afin de contrôler le fonctionnement de la diode électroluminescente. De façon avantageuse, la grille 323 de chaque transistor recouvre au moins une partie des couches constituant la diode. Ainsi, la couche supérieure 214 de la diode joue également le rôle de source pour les transistors 320 NMOS. Cela permet avantageusement d'optimiser le fonctionnement de la diode en favorisant une meilleure conduction du courant entre les transistors 320 et la diode. En effet, contrairement au premier mode de réalisation, il n'est plus nécessaire que le courant passe par une source du transistor distincte de la diode pour l'alimenter. De ce fait, une meilleure conduction du courant est assurée entre le transistor et la diode. Ceci permet également de réaliser la fabrication de tout le dispositif sur le même flot de production, avec un meilleur contrôle qualité et pour un coût de fabrication moindre.

De façon similaire, la photodiode est connectée à quatre transistors 310 de type « P ». Les grilles 313 des transistors 310 recouvrent au moins une partie des couches constituant la photodiode de sorte à s'affranchir de l'utilisation d'un drain pour assurer la conduction d'un courant entre les transistors 310 et la photodiode.

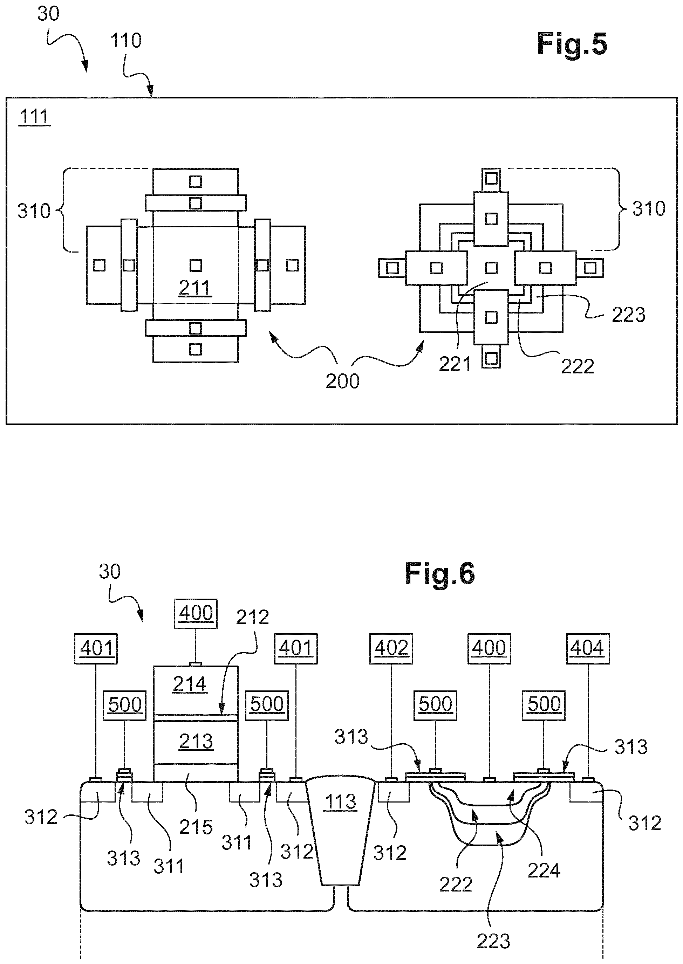

Les figures 5 et 6 illustrent un circuit intégré 30 présentant un troisième type d'unité de communication. Cette configuration est une combinaison des deux précédentes. En effet, comme illustré à la figure 6, l'unité de communication 200 comprend un moyen d'émission identique à celui décrit par le premier type d'unité de communication et le moyen de réception est similaire à celui décrit par le deuxième type d'unité de communication. Il est à souligner que ce troisième type d'unité de communication utilise uniquement des transistors PMOS, tant pour la diode électroluminescente que pour la photodiode, contrairement aux types 1 et 2 qui utilisent à la fois des PMOS et des NMOS.

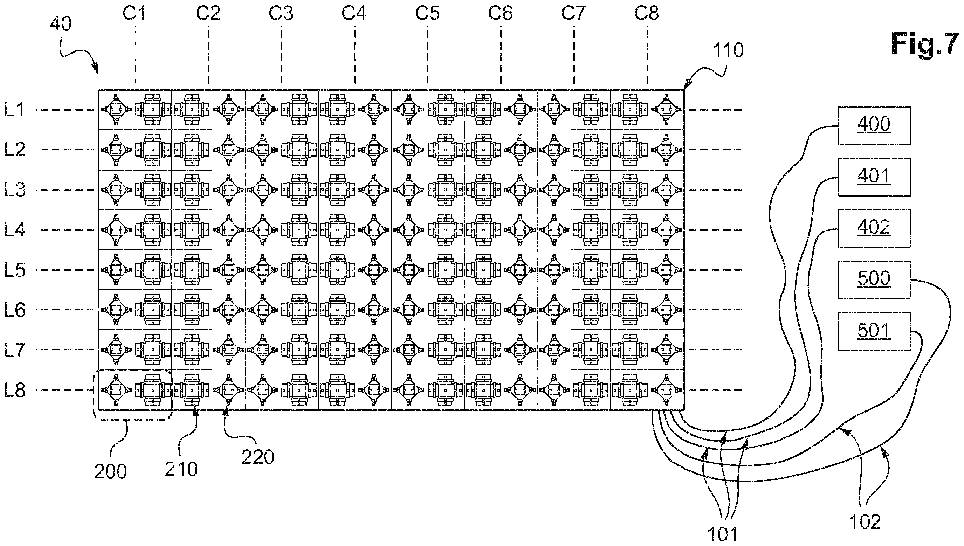

Le circuit intégré selon l'invention comprend plusieurs unités de commande telles que décrites ci-dessus afin d'augmenter le débit d'information transmise entre deux circuits intégrés. La figure 7 illustre un mode de réalisation d'un circuit intégré 40 selon la présente demande. Selon cet exemple, plusieurs unités de communication 200 telle que décrite ci-dessus sont agencées sur une face avant 111 d'un substrat 110. Bien entendu, le circuit intégré peut comprendre des unités de communication identiques correspondant au premier ou au deuxième ou bien au troisième types d'unités de communication décrits ci-dessus.

Sur la figure 7, les unités de communication sont agencées sur le substrat 110 pour former huit lignes numérotées de L1 à L8. Les unités de communication 10 sont également agencées pour que leur moyen d'émission 210 et les moyens de réception 220 forment des colonnes distinctes numérotées de C1 à C8. Selon le présent exemple, les unités de communication forment une matrice de 64 éléments. Bien entendu, ce nombre peut être adapté en fonction du débit d'information que l'on souhaite.

Chaque unité de communication 200 est individuellement connectée à la terre 400, à une source de courant 401, à un dispositif de mesure 402 par l'intermédiaire de liaisons électriques 101, ainsi qu'aux moyens de contrôle 500 et 501 décrit ci-dessus par l'intermédiaire de liaisons électriques 102. Plus précisément, les unités de communication sont agencées sur le substrat 110 de sorte que le moyen de contrôle 500 puisse contrôler la fréquence de chaque moyen d'émission 210, de sorte à associer une même fréquence d'émission pour tous les moyens d'émission composant une même ligne. A l'inverse, une fréquence d'émission différente est associée pour chaque ligne. La fréquence des ondes électromagnétiques émises par les moyens d'émission 210 peut être comprise entre 1Hz et 4GHz. Selon le présent exemple, il est associé aux huit lignes formant la matrice les fréquences d'émission suivantes : 607MHz pour la ligne L1, 661MHz pour la ligne L2, 719MHz pour la ligne L3, 773MHz pour la ligne L4, 829MHz pour la ligne L5, 887MHz pour la ligne L6, 947MHz pour la ligne L7, 997MHz pour la ligne L8.

Afin d'éviter une confusion entre les informations émises par les moyens d'émission appartenant à une même ligne, un type différent de diodes électroluminescentes émettant à une plage de longueur d'onde donnée est utilisé pour chaque colonne. En outre, un filtre optique spécifique à cette plage de longueur d'onde donnée (non représenté) est placé devant chaque photodiode de cette colonne, de sorte que les unités de communication 200 appartenant à une même colonne émettent et détectent un rayonnement électromagnétique dans une plage de longueur d'onde distincte des autres colonnes. Bien entendu, les filtres optiques spécifiques peuvent comprendre une plage de longueur d'onde qui soit commune. De préférence, cette plage est la plus petite possible. Selon le présent exemple, il est associé aux colonnes les longueurs d'onde suivantes : 405nm pour la colonne C1, 450nm pour la colonne C2, 470nm pour la colonne C3, 510nm pour la colonne C4, 550nm pour la colonne C5, 590nm pour colonne C6, 625nm pour colonne C7, 640nm pour la colonne C8.

Bien entendu, diverses autres modifications au dispositif selon l'invention peuvent être envisagées dans le cadre des revendications annexées.

## Revendications

1. Circuit intégré, apte à transmettre de l'information à distance par l'intermédiaire de faisceaux lumineux, comprenant un substrat (110) sur lequel sont agencées sur une même face (111), plusieurs unités de communication (200) comprenant chacune un moyen d'émission (210) et un moyen de réception (220) d'un rayonnement électromagnétique dont la plage de longueur d'onde est comprise entre 200nm et 3µm, de préférence comprise entre 380nm et 780nm, et chaque unité de communication (200) est apte à échanger de l'information avec une autre unité de communication agencée sur un autre circuit intégré, par l'intermédiaire du rayonnement électromagnétique de façon bidirectionnelle, à chaque unité de communication (200) est associée une combinaison unique de plage de longueur d'onde de rayonnement électromagnétique et de fréquence d'échange d'information, **caractérisé en ce que** sur une même face (111) d'un substrat (110) du circuit intégré (40) sont agencées plusieurs unités de communication (200) sous forme de lignes et de colonnes, et aux unités de communication (200) formant une colonne est associée une plage unique de longueurs d'onde d'un rayonnement électromagnétique et aux unités de communication (200) formant une ligne est associée une fréquence unique d'échange d'information.

2. Circuit intégré selon la revendication 1, **caractérisé en ce que** le substrat comprend sur une même face au moins deux unités de communication (200) distinctes, et **en ce que** lesdites unités de communication comprennent un moyen d'émission et un moyen de réception d'un rayonnement électromagnétique dans une même plage de longueur d'onde.

3. Circuit intégré selon la revendication 1 ou 2, **caractérisé en ce que** le substrat comprend sur une même face au moins deux unités de communication (200) distinctes, et **en ce que** lesdites unités de communication (200) échangent de l'information à une même fréquence.

4. Circuit intégré selon l'une des revendications 1 à 3 **caractérisé en ce que** le moyen d'émission (210) et/ou le moyen de réception (220) comprend une jonction de type P-N et au moins un transistor (310, 320) à effet de champ, dont la grille (313, 323) recouvre au moins partiellement les zones dopées négativement (214, 223) et positivement (213, 224), de ladite jonction, de sorte qu'une desdites zones dopées forme à la fois la source ou le drain du transistor.

5. Circuit intégré selon l'une des revendications 1 à 4, **caractérisé en ce qu'**un moyen d'émission (210) comprend une diode électroluminescente et **en ce qu'**un moyen de réception (220) comprend une photodiode.

6. Circuit intégré selon l'une des revendications 1 à 5, **caractérisé en ce qu'**un filtre optique est agencé devant au moins une diode électroluminescente et/ou au moins une photodiode.

7. Circuit intégré selon l'une des revendications 1 à 6, **caractérisé en ce qu'**un filtre optique spécifique est placé devant chaque colonne formée par les unités de communication (200).

8. Circuit intégré selon l'une des revendications 1 à 7, **caractérisé en ce qu'**au moins un transistor (310, 320) est connecté à un moyen d'émission (210) et au moins un autre transistor (310, 320) est connecté à un moyen de réception (220), chaque transistor comprenant un canal de conduction, et **en ce qu'**au moins un transistor connecté au moyen d'émission comporte un canal de conduction plus large et/ou plus court qu'un transistor connecté au moyen de réception.

9. Procédé de fabrication d'un circuit intégré selon l'une des revendications 1 à 8 comprenant au moins une étape consistant à réaliser de façon symétrique, sur le substrat du circuit intégré, deux transistors (310, 320) à effet de champ à grille isolée de type P et N.

10. Procédé de fabrication d'un circuit intégré selon l'une des revendications 1 à 8, comprenant les étapes suivantes :
- réalisation d'un transistor (310) de type P dans une zone active du circuit intégré de sorte que le transistor (310) soit entouré d'une tranchée d'isolation (113) et présent dans un caisson d'isolation (112a) dopé faiblement de type N ;
- recouvrement d'au moins une partie du drain (311) du transistor (310) par une diode électroluminescente.

11. Procédé de fabrication d'un circuit intégré selon l'une des revendications 1 à 8, comprenant les étapes suivantes :
- réalisation d'un transistor (320) de type N dans une zone active du circuit intégré de sorte que le transistor soit entouré d'une tranchée d'isolation (113) et présent dans un caisson d'isolation (112b) dopé faiblement de type P ;
- recouvrement d'au moins une partie de la source (322) du transistor par une photodiode.

12. Procédé de fabrication d'un circuit intégré selon l'une des revendications 1 à 8, comprenant les étapes suivantes :
- réalisation d'une diode électroluminescente comprenant au moins une zone dopée (213) de type P et au moins une zone dopée (214) de type N, lesdites zones étant séparées une couche de puits quantiques (212) ;
- réalisation d'un transistor (320) de type N dans une zone active du circuit intégré de sorte que le transistor (320) soit présent dans un caisson d'isolation (112b) dopé de type P, et qu'une grille (323) du transistor (320) recouvre au moins partiellement la source (322) dudit transistor, **caractérisé en ce que** la source (322) du transistor est commun à une zone dopée (214) de type N de la diode électroluminescente, et **en ce qu'**une zone dopée (213) de type P de la diode électroluminescente forme au moins une partie du canal de conduction du transistor (320).

13. Procédé de fabrication d'un circuit intégré selon l'une des revendications 1 à 8, comprenant les étapes suivantes :
- réalisation d'une photodiode comprenant au moins une zone dopée (223) de type N et au moins une zone dopée (224) de type P, les zones dopées étant séparées par une couche (222) apte à créer une zone de déplétion entre lesdites zones ;
- réalisation d'un transistor (310) de type P dans une zone active du circuit intégré de sorte que le transistor soit présent dans un caisson d'isolation (112a) dopé de type N, et qu'une grille (313) recouvre au moins partiellement le drain (311) du transistor, **caractérisé en ce que** le drain (311) du transistor est commun à une zone dopée (224) de type P de la photodiode, et **en ce qu'**une zone dopée (223) de type N de la photodiode forme au moins une partie du canal de conduction du transistor (310).

14. Kit comportant au moins deux circuits intégrés selon l'une des revendications 1 à 8.

## Patentansprüche

1. Integrierter Schaltkreis, der in der Lage ist, Informationen auf Entfernung mittels Lichtstrahlen zu übertragen, umfassend ein Substrat (110), auf dem auf ein und derselben Seite (111) mehrere Kommunikationseinheiten (200) angeordnet sind, die jede ein Sendemittel (210) und ein Empfangsmittel (220) einer elektromagnetischen Strahlung umfassen, deren Wellenlängenbereich im Bereich zwischen 200 nm und 3 µm, vorzugsweise im Bereich zwischen 380 nm und 780 nm beträgt, und jede Kommunikationseinheit (200) in der Lage ist, Informationen mit einer anderen Kommunikationseinheit, die auf einem anderen integrierten Schaltkreis angeordnet ist, mittels der elektromagnetischen Strahlung in bidirektionaler Weise auszutauschen, jeder Kommunikationseinheit (200) eine eindeutige Kombination aus Wellenlängenbereich elektromagnetischer Strahlung und Informationsaustauschfrequenz zugeordnet ist, **dadurch gekennzeichnet, dass** auf ein und derselben Seite (111) eines Substrats (110) des integrierten Schaltkreises (40) mehrere Kommunikationseinheiten (200) in Form von Zeilen und von Spalten angeordnet sind, und den Kommunikationseinheiten (200), die eine Spalte bilden, ein eindeutiger Wellenlängenbereich einer elektromagnetischen Strahlung zugeordnet ist, und den Kommunikationseinheiten (200), die eine Zeile bilden, eine eindeutige Informationsaustauschfrequenz zugeordnet ist.

2. Integrierter Schaltkreis nach Anspruch 1, **dadurch gekennzeichnet, dass** das Substrat auf ein und derselben Seite mindestens zwei separate Kommunikationseinheiten (200) umfasst, und dadurch, dass die Kommunikationseinheiten ein Sendemittel und ein Empfangsmittel einer elektromagnetischen Strahlung in ein und demselben Wellenlängenbereich umfassen.

3. Integrierter Schaltkreis nach Anspruch 1 oder 2, **dadurch gekennzeichnet, dass** das Substrat auf ein und derselben Seite mindestens zwei separate Kommunikationseinheiten (200) umfasst, und dadurch, dass die Kommunikationseinheiten (200) Informationen auf ein und derselben Frequenz austauschen.

4. Integrierter Schaltkreis nach einem der Ansprüche 1 bis 3, **dadurch gekennzeichnet, dass** das Sendemittel (210) und/oder das Empfangsmittel (220) einen Übergang vom P-N-Typ und mindestens einen Feldeffekttransistor (310, 320) umfasst, dessen Gatter (313, 323) die negativ (214, 223) und positiv dotierten Zonen (213, 224) des Übergangs mindestens teilweise überdeckt, sodass eine der dotierten Zonen gleichzeitig die Quelle oder die Senke des Transistors bildet.

5. Integrierter Schaltkreis nach einem der Ansprüche 1 bis 4, **dadurch gekennzeichnet, dass** ein Sendemittel (210) eine Leuchtdiode umfasst, und dadurch, dass ein Empfangsmittel (220) eine Photodiode umfasst.

6. Integrierter Schaltkreis nach einem der Ansprüche 1 bis 5, **dadurch gekennzeichnet, dass** vor mindestens einer Leuchtdiode und/oder mindestens einer Photodiode ein optischer Filter angeordnet ist.

7. Integrierter Schaltkreis nach einem der Ansprüche 1 bis 6, **dadurch gekennzeichnet, dass** vor jeder Spalte, die von den Kommunikationseinheiten (200) gebildet wird, ein spezifischer optischer Filter platziert ist.

8. Integrierter Schaltkreis nach einem der Ansprüche 1 bis 7, **dadurch gekennzeichnet, dass** mindestens ein Transistor (310, 320) mit einem Sendemittel (210) verbunden ist, und mindestens ein anderer Transistor (310, 320) mit einem Empfangsmittel (220) verbunden ist, wobei jeder Transistor einen Leitkanal umfasst, und dadurch, dass mindestens ein mit dem Sendemittel verbundener Transistor einen breiteren und/oder kürzeren Leitkanal umfasst als ein Transistor, der mit dem Empfangsmittel verbunden ist.

9. Verfahren zur Herstellung eines integrierten Schaltkreises nach einem der Ansprüche 1 bis 8, umfassend mindestens einen Schritt, der darin besteht, auf dem Substrat des integrierten Schaltkreises in symmetrischer Weise zwei Feldeffekttransistoren (310, 320) mit isoliertem Gatter vom P- und N-Typ auszuführen.

10. Verfahren zur Herstellung eines integrierten Schaltkreises nach einem der Ansprüche 1 bis 8, umfassend die folgenden Schritte:
- Ausführen eines Transistors (310) vom P-Typ in einer aktiven Zone des integrierten Schaltkreises so, dass der Transistor (310) von einem Isolationsgraben (113) umgeben ist und in einer schwach dotierten Isolationskammer (112a) vom N-Typ vorliegt;
- Überdecken von mindestens einem Teil der Senke (311) des Transistors (310) mit einer Leuchtdiode.

11. Verfahren zur Herstellung eines integrierten Schaltkreises nach einem der Ansprüche 1 bis 8, umfassend die folgenden Schritte:
- Ausführen eines Transistors (320) vom N-Typ in einer aktiven Zone des integrierten Schaltkreises so, dass der Transistor von einem Isolationsgraben (113) umgeben ist und in einer schwach dotierten Isolationskammer (112b) vom P-Typ vorliegt;
- Überdecken von mindestens einem Teil der Quelle (322) des Transistors mit einer Photodiode.

12. Verfahren zur Herstellung eines integrierten Schaltkreises nach einem der Ansprüche 1 bis 8, umfassend die folgenden Schritte:
- Ausführen einer Leuchtdiode, die mindestens eine dotierte Zone (213) vom P-Typ und mindestens eine dotierte Zone (214) vom N-Typ umfasst, wobei die Zonen eine Quantentopfschicht (212) getrennt sind;
- Ausführen eines Transistors (320) vom N-Typ in einer aktiven Zone des integrierten Schaltkreises so, dass der Transistor (320) in einer dotierten Isolationskammer (112b) vom P-Typ vorliegt, und dass ein Gatter (323) des Transistors (320) die Quelle (322) des Transistors mindestens teilweise überdeckt, **dadurch gekennzeichnet, dass** die Quelle (322) des Transistors einer dotierten Zone (214) vom N-Typ der Leuchtdiode gemein ist, und dadurch, dass eine dotierte Zone (213) vom P-Typ der Leuchtdiode mindestens einen Teil des Leitkanals des Transistors (320) bildet.

13. Verfahren zur Herstellung eines integrierten Schaltkreises nach einem der Ansprüche 1 bis 8, umfassend die folgenden Schritte:
- Ausführen einer Photodiode, die mindestens eine dotierte Zone (223) vom N-Typ und mindestens eine dotierte Zone (224) vom P-Typ umfasst, wobei die dotierten Zonen durch eine Schicht (222) getrennt sind, die in der Lage ist, eine Verarmungszone zwischen den Zonen zu erzeugen;
- Ausführen eines Transistors (310) vom P-Typ in einer aktiven Zone des integrierten Schaltkreises so, dass der Transistor in einer dotierten Isolationskammer (112a) vom N-Typ vorliegt, und dass ein Gatter (313) die Senke (311) des Transistors mindestens teilweise überdeckt, **dadurch gekennzeichnet, dass** die Senke (311) des Transistors einer dotierten Zone (224) vom P-Typ der Photodiode gemein ist, und dadurch, dass eine dotierte Zone (223) vom N-Typ der Photodiode mindestens einen Teil des Leitkanals des Transistors (310) bildet.

14. Set, das mindestens zwei integrierte Schaltkreise nach einem der Ansprüche 1 bis 8 umfasst.

## Claims

1. Integrated circuit, capable of transmitting information remotely by way of light beams, comprising a substrate (110) on which are arranged on one same face (111), several communication units (200) each comprising a means for emitting (210) and a means for receiving (220) an electromagnetic beam, of which the wavelength range is between 200nm and 3µm, preferably between 380nm and 780nm, and each communication unit (200) is capable of exchanging information with another communication unit arranged on another integrated circuit, by way of the two-directional electromagnetic beam, to each communication unit (200) is associated a single combination of electromagnetic beam wavelength range and information exchange frequency, **characterised in that** on one same face (111) of a substrate (110) of the integrated circuit (40) are arranged several communication units (200) in the form of lines and columns, and at the communication units (200) forming a column is associated a single range of electromagnetic beam wavelengths and at the communication units (200) forming a line is associated a single information exchange frequency.

2. Integrated circuit according to claim 1, **characterised in that** the substrate comprises on one same face, at least two separate communication units (200), and **in that** said communication units comprise a means for emitting and a means for receiving an electromagnetic beam in one same wavelength range.

3. Integrated circuit according to claim 1 or 2, **characterised in that** the substrate comprises on one same face, at least two separate communication units (200), and **in that** said communication units (200) exchange information at a same frequency.

4. Integrated circuit according to one of claims 1 to 3, **characterised in that** the emission means (210) and/or the receiving means (220) comprises a P-N type junction and at least one field-effect transistor (310, 320), of which the grid (313, 323) covers, at least partially, the negatively (214, 223) and positively (213, 224) boosted zones, of said junction, such that one of said boosted zones forms both the source or the drain of the transistor.

5. Integrated circuit according to one of claims 1 to 4, **characterised in that** an emission means (210) comprises a light-emitting diode and **in that** a receiving means (220) comprises a photodiode.

6. Integrated circuit according to one of claims 1 to 5, **characterised in that** an optical filter is arranged before at least one light-emitting diode and/or at least one photodiode.

7. Integrated circuit according to one of claims 1 to 6, **characterised in that** a specific optical filter is placed before each column formed by the communication units (200).

8. Integrated circuit according to one of claims 1 to 7, **characterised in that** at least one transistor (310, 320) is connected to an emission means (210) and at least one other transistor (310, 320) is connected to a receiving means (220), each transistor comprising a conduction channel, and **in that** at least one transistor connected to the emission means comprises a wider and/or shorter conduction channel than a transistor connected to the receiving means.

9. Method for producing an integrated circuit according to one of claims 1 to 8, comprising at least one step consisting of symmetrically producing, on the substrate of the integrated circuit, two field-effect transistors (310, 320) with a P and N type insulated grid.

10. Method for producing an integrated circuit according to one of claims 1 to 8, comprising the following steps:
- producing a P type transistor (310) in an active zone of the integrated circuit, such that the transistor (310) is surrounded by an insulation trench (113) and present in a slightly boosted N type insulation box (112a);
- covering at least one part of the drain (311) of the transistor (310) with a light-emitting diode.

11. Method for producing an integrated circuit according to one of claims 1 to 8, comprising the following steps:
- producing an N type transistor (320) in an active zone of the integrated circuit, such that the transistor is surrounded by an insulation trench (113) and present in a slightly boosted P type insulation box (112b);
- covering at least one part of the source (322) of the transistor with a photodiode.

12. Method for producing an integrated circuit according to one of claims 1 to 8, comprising the following steps:
- producing a light-emitting diode comprising at least one P type boosted zone (213) and at least one N type boosted zone (214), said zones being separated by a layer of quantum wells (212);
- producing an N type transistor (320) in an active zone of the integrated circuit, such that the transistor (320) is present in a P type boosted insulation box (112b), and that a grid (323) of the transistor (320) covers at least partially the source (322) of said transistor, **characterised in that** the source (322) of the transistor is shared with an N type boosted zone (214) of the light-emitting diode, and **in that** a P type boosted zone (213) of the light-emitting diode forms at least one part of the conduction channel of the transistor (320).

13. Method for producing an integrated circuit according to one of claims 1 to 8, comprising the following steps:
- producing a photodiode comprising at least one N type boosted zone (223) and at least one P type boosted zone (224), the boosted zones being separated by a layer (222) capable of creating a depletion zone between said zones;
- producing a P type transistor (310) in an active zone of the integrated circuit, such that the transistor is present in an N type boosted insulation box (112a), and that a grid (313) covers at least partially the drain (311) of the transistor, **characterised in that** the drain (311) of the transistor is shared with a P type boosted zone (224) of the photodiode, and **in that** an N type boosted zone (223) of the photodiode forms at least one part of the conduction channel of the transistor (310).

14. Kit comprising at least two integrated circuit according to one of claims 1 to 8.
